# EUROPEAN PATENT APPLICATION

(11) **EP 1 923 915 A2**
(43) Date of publication of application: **21.05.2008**
(21) Application number: 07253040.5
(22) Date of filing: 02.08.2007
(51) Int. Cl.: H01L 23/427

(54) **Heat dissipating system having a heat dissipating cavity body**

(30) Priority: 14.11.2006 CN 200610145734
(71) Applicant: Orra Corporation, Santa Clara, San Diego, CA 95054 (US)
(72) Inventor: Luo, Chin-Kuang, Taichung City (TW)
(74) Representative: Albutt, Anthony John

(57) **Abstract**

A heat dissipating system includes a heat dissipating cavity body (3, 7, 3') defining a receiving space (31, 71, 31') and having a bottom wall (34, 74, 34') adapted to contact a heat source (61), a working fluid (30) disposed in the receiving space (31, 71, 31') and adapted to absorb heat generated by the heat source (61), and a heat exchange unit (4) for exchanging heat with the working fluid (30). The bottom wall (34, 74, 34') is made of a thin metal plate, and is flexible to deform so that when the bottom wall (34, 74, 34') is pressed against the heat source (61), the bottom wall (34, 74, 34') conforms to and contacts tightly a contact surface of the heat source (61).

## Description

The invention relates to heat dissipation, more particularly to a heat dissipating system having a heat dissipating cavity body.

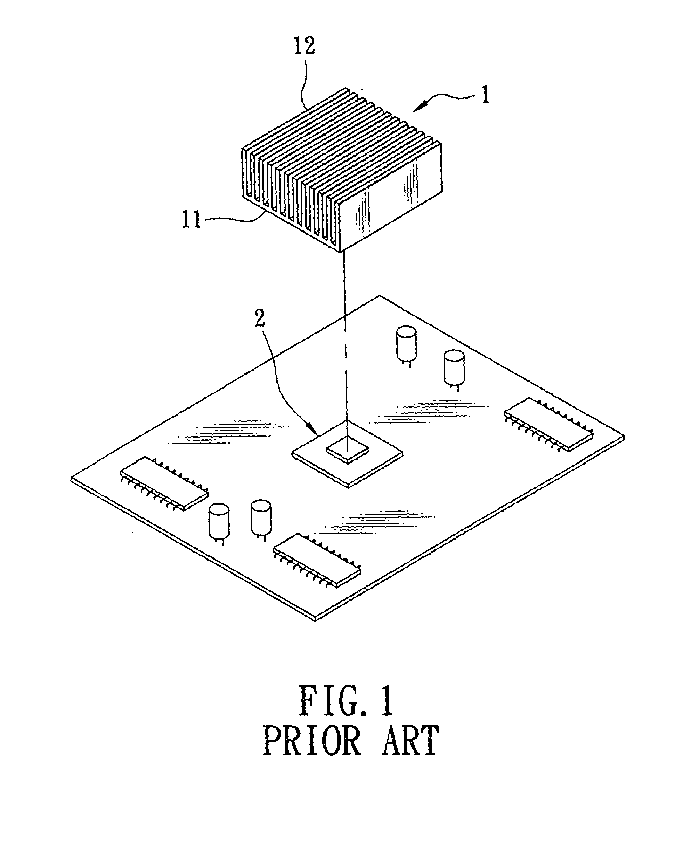

Referring to Figure 1, a conventional heat sink 1 includes a substantially large contact surface 11 in contact with a heat source 2, and a plurality of heat dissipating fins 12. The contact surface 11 absorbs heat generated by the heat source 2, and the heat is dissipated through the heat dissipating fins 12 which exchange heat with external cold air by natural convection.

Since the contact parts of the heat sink 1 and the heat source 2 are rigid, and since errors in surface flatness of the contact surfaces inevitably occur, a small gap is typically formed between the contact surface 11 of the heat sink 1 and the heat source 2. As such, the contact surface 11 of the heat sink 1 cannot contact tightly the heat source 2, thereby affecting the heat dissipating efficiencyof the heat sink 1 . Further, since the heat dissipating purpose of the heat sink 1 is achieved by increasing the heat dissipating area thereof, the volume of the conventional heat sink 1 is thus very large. Moreover, because the area of heat conduction is limited, the temperature of the conventional heat sink 1 increases after a long period of use, thereby adversely affecting the heat dissipating effect.

Therefore, the object of the present invention is to provide a heat dissipating system having a heat dissipating cavity body so as to enhance the heat dissipating effect and efficiency of the heat dissipating system.

According to one aspect of this invention, a heat dissipating system comprises a heat dissipating cavity body defining a receiving space and having a bottom wall adapted to contact a heat source, a working fluid disposed in the receiving space and adapted to absorb heat generated by the heat source, and a heat exchange unit for exchanging heat with the working fluid. The bottom wall is made of a thin metal plate, and is flexible to deform so that when the bottom wall is pressed against the heat source, the bottom wall conforms to and contacts tightly a contact surface of the heat source.

According to another aspect of this invention, a heat dissipating cavity body is adapted to contact a heat source, and comprises top and bottom walls, and a surrounding wall connected between the top and bottom walls to define a receiving space which is adapted to contain a working fluid. The bottom wall is made of a thin metal plate, and is flexible to deform so that when the bottom wall is pressed against the heat source, the bottom wall conforms to and contacts tightly a contact surface of the heat source.

Other features and advantages of the present invention will become apparent in the following detailed description of the preferred embodiments with reference to the accompanying drawings, of which:
Figure 1 is a perspective view of a conventional heat sink shown prior to being attached to a heat source;
Figure 2 is a schematic front view of the first preferred embodiment of a heat dissipating system according to the present invention;
Figure 3 is a schematic side view of the first preferred embodiment;
Figure 4 is an enlarged fragmentary sectional view of a heat dissipating cavity body of the first preferred embodiment;
Figure 5 is a fragmentary sectional view of a condenser of the first preferred embodiment;
Figure 6 is an enlarged sectional view of a heat dissipating cavity body of a heat dissipating system according to the second preferred embodiment of the present invention; and
Figure 7 is a partly sectional view of a heat dissipating system according to the third preferred embodiment of the present invention.

Before the present invention is described in greater detail with reference to the following preferred embodiments, it should be noted that like elements are denoted by the same reference numerals throughout the disclosure.

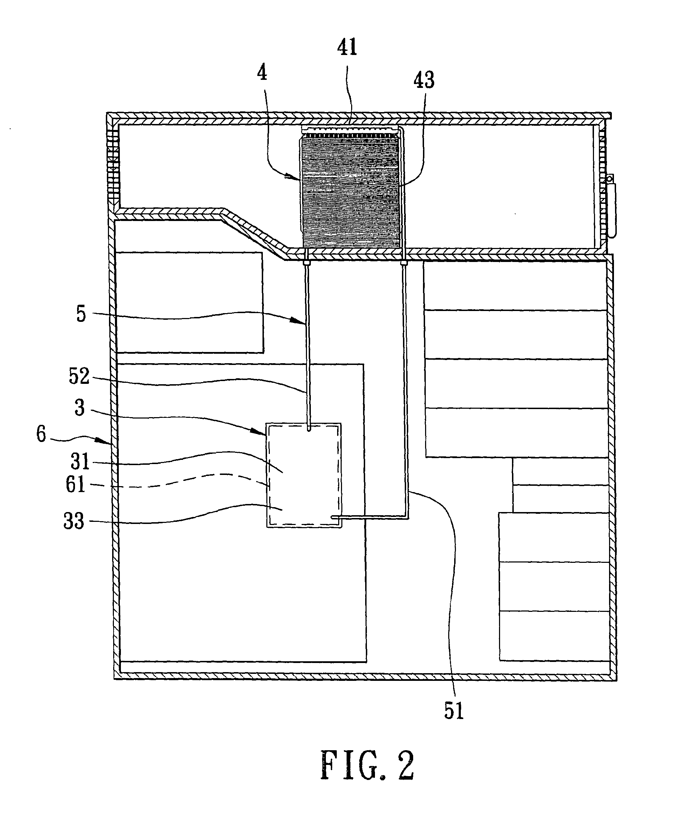

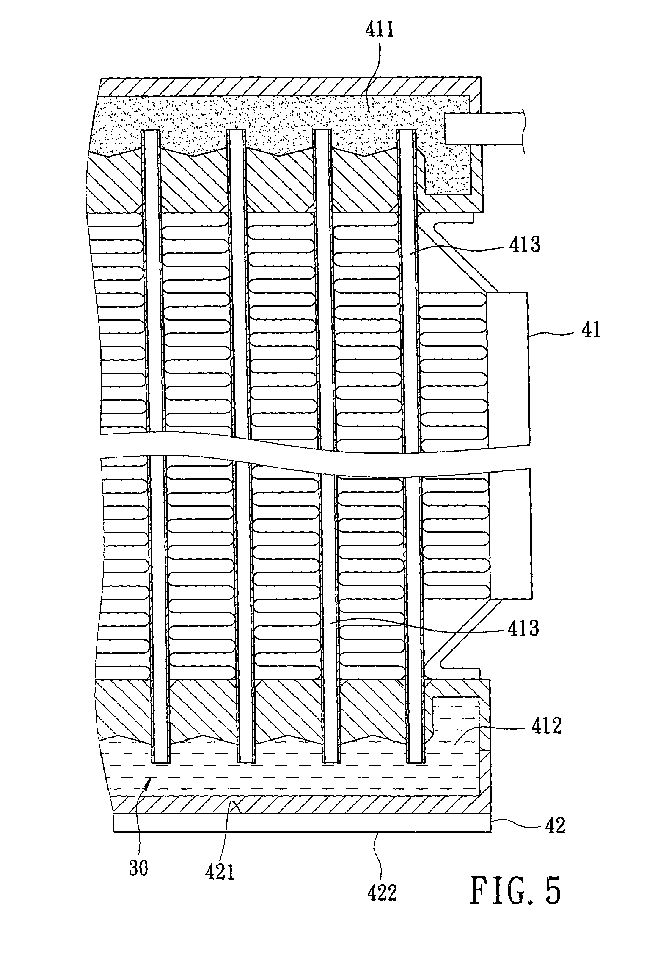

Referring to Figures 2 to 5, the first preferred embodiment of a heat dissipating system according to the present invention is adapted to be installed in a computer module 6, and is shown to comprise a heat dissipating cavity body 3 and a heat exchange unit 4.

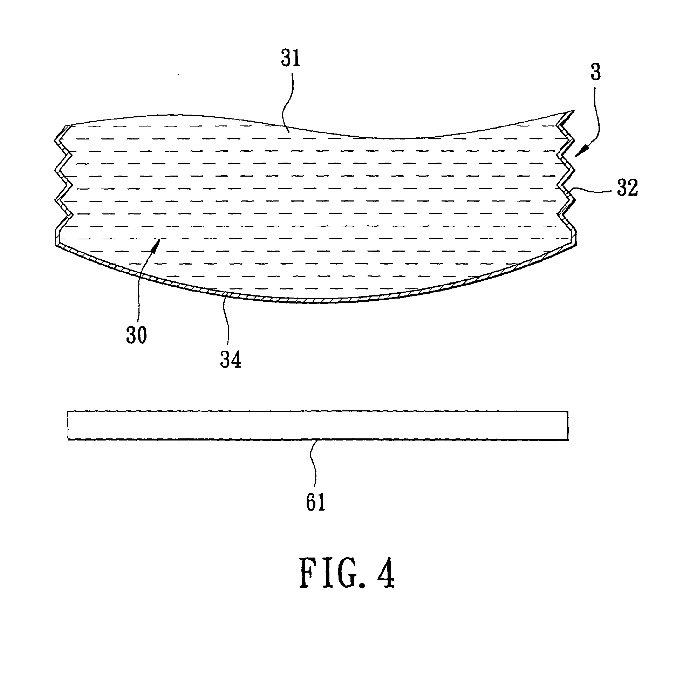

The heat dissipating cavity body 3, in this embodiment, is adapted to be disposed in a lower chamber of the computer module 6, and is made of a thin metal plate having a thickness of below 0.5mm. As shown in Figure 4, the heat dissipating cavity body 3 has top and bottom walls 33, 34, and a surrounding wall 32 connected between the top and bottom walls 33, 34 to define a receiving space 31. The bottom wall 34 is convexed downwardly in a normal state, and is adapted to contact a heat source 61 of the computer module 6. The surrounding wall 32 is pleated. In Figure 2, the top and bottom walls 33, 34 (only the top wall 33 is visible) are placed vertically.

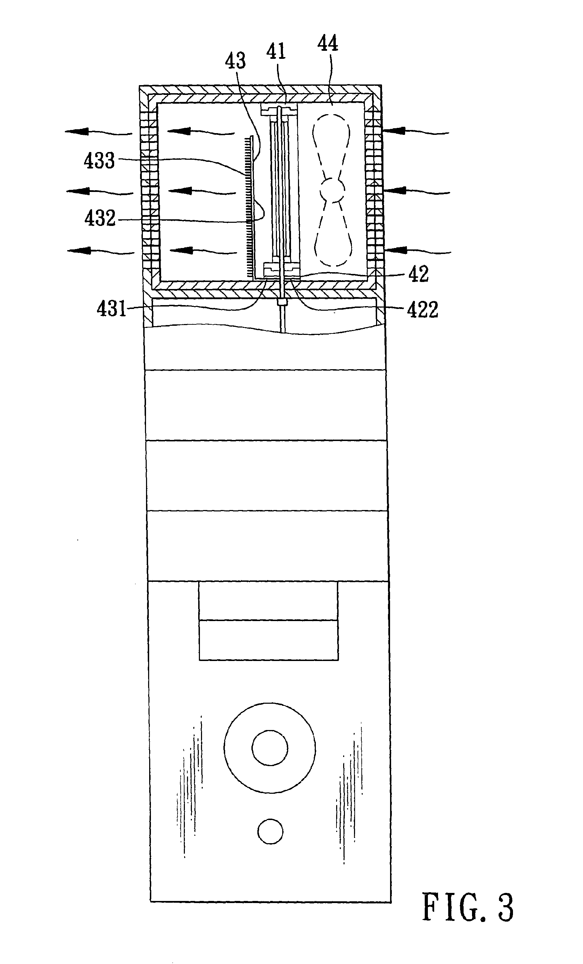

The heat exchange unit 4 includes a condenser 41, a thermoelectric cooler 42, a heat sink 43, and a fan 44. The condenser 41 has a vapor-receiving section 411 formed on a top end thereof, a liquid-receiving section 412 formed on a bottom end thereof, and a plurality of channels 413 connected between the vapor-receiving and liquid-receiving sections 411, 412. The thermoelectric cooler 42 is controlled through a circuit, and has a cold side 421 in contact with the liquid-receiving section 412, and a hot side 422 opposite to the cold side 421. The cold side 421 has a cooling function so as to keep the liquid-receiving section 412 at a constant temperature. The heat sink 43 is disposed proximate to the condenser 41, and has an L-shaped configuration. The heat sink 43 has a horizontal plate 431 in contact with the hot side 422 of the thermoelectric cooler 42, a vertical plate 432 connected to an end periphery of the horizontal plate 431 and parallel to the condenser 41, and a plurality of fins 433 provided on the vertical plate 432. The fan 44 is disposed proximate to the condenser 41 and the heat sink 43, and directs a current of cold air toward the condenser 41 and the heat sink 43, as best shown in Figure 3.

A tubing unit 5, in this embodiment, interconnects the heat dissipating cavity body 3 and the condenser 41, and includes a vapor-flowing tube 51 connected fluidly to the cavity body 3 and the vapor-receiving section 411 of the condenser 41, and a liquid-flowing tube 52 connected fluidly to the cavity body 3 and the liquid-receiving section 412 of the condenser 41. As such, the vapor-flowing and liquid-flowing tubes 51, 52, the condenser 41, and the cavity body 3 form a closed circulating loop.

A working fluid 30 is condensable and is injected into the heat dissipating system of the present invention after the vapor-flowing and liquid-flowing tubes 51, 52, the cavity body 3, and the condenser 41 are evacuated, so that the working fluid 30 circulates in a vacuum environment. In this embodiment, the working fluid 30 is a coolant that is in a liquid state at room temperature. Alternatively, the working fluid 30 may be a super-thermal-conductive liquid.

During assembly, the bottom wall 34 of the heat dissipating cavity body 3 is placed in contact with the heat source 61 of the computer module 6. Because the cavity body 3 is made of a thin metal plate, the bottom wall 34 and the pleated surrounding wall 32 are flexible to deform easily when acted upon by an external force. As such, when the bottom wall 34 is pressed against the heat source 61, the bottom wall 34 conforms to and contacts tightly a contact surface of the heat source 61, thereby enhancing tight contact between the cavity body 3 and the heat source 61.

Initially, the working fluid 30 is in a liquid state and is contained in the receiving space 31 of the cavity body 3. After the computer module 6 is switched on, the liquid-state working fluid 30 in the cavity body 3 absorbs heat generated by the heat source 61 through heat conduction, and is vaporized. The pressure inside the cavity body 3 increases as the working fluid 30 is vaporized, and the vaporized working fluid 30 is pressurized to flow upward by natural convection through the vapor-flowing tube 51 from a high-density region, which is the cavity body 3, into a low-density region, which is the vapor-receiving section 411 of the condenser 41. At this time, the fan 44 blows cold air toward the condenser 41 and the heat sink 43 so that the condenser 41 and the heat sink 43 exchange heat with the cold air. The vaporized working fluid 30 from the vapor-flowing tube 51 is condensed in the condenser 41, and flows downward through the channels 413 by gravity into the liquid-receiving section 412 of the condenser 4.

Through the cooling function of the cold side 421 of the thermoelectric cooler 42, the temperature of the working fluid 30 in a condensed state and in the liquid-receiving section 412 of the condenser 41 continues to drop to a preset value, and the hot side 422 of the thermoelectric cooler 42 transfers the heat from the condensed working fluid 30 to the heat sink 43, which dissipates the heat. The cooled condensed working fluid 30 in the liquid-receiving section 412 then flows back into the receiving space 31 of the cavity body 3 through the liquid-flowing tube 52 by gravity so as to repeat the aforementioned steps. Hence, by circulating the working fluid 30 through the condenser 41, the cavity body 3, and the vapor-flowing and liquid-flowing tubes 51, 52, heat is effectively dissipated.

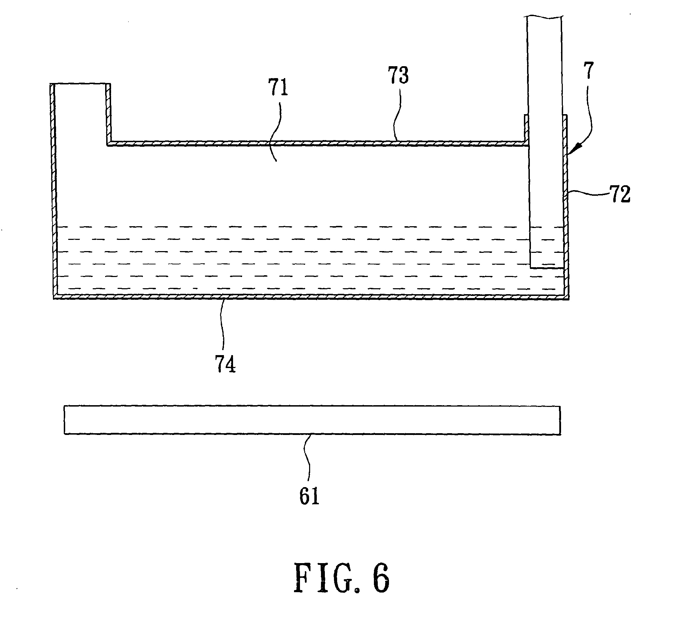

Referring to Figure 6, a heat dissipating system according to the second preferred embodiment of the present invention is shown to be similar to the first preferred embodiment. The heat dissipating cavity body 7 is made of a thin metal plate. However, in this embodiment, the bottom wall 74 of the heat dissipating cavity body 7 is flat. When the bottom wall 74 is pressed against the contact surface of the heat source 61, the bottom wall 74 similarly conforms to and contacts tightly the contact surface of the heat source 61.

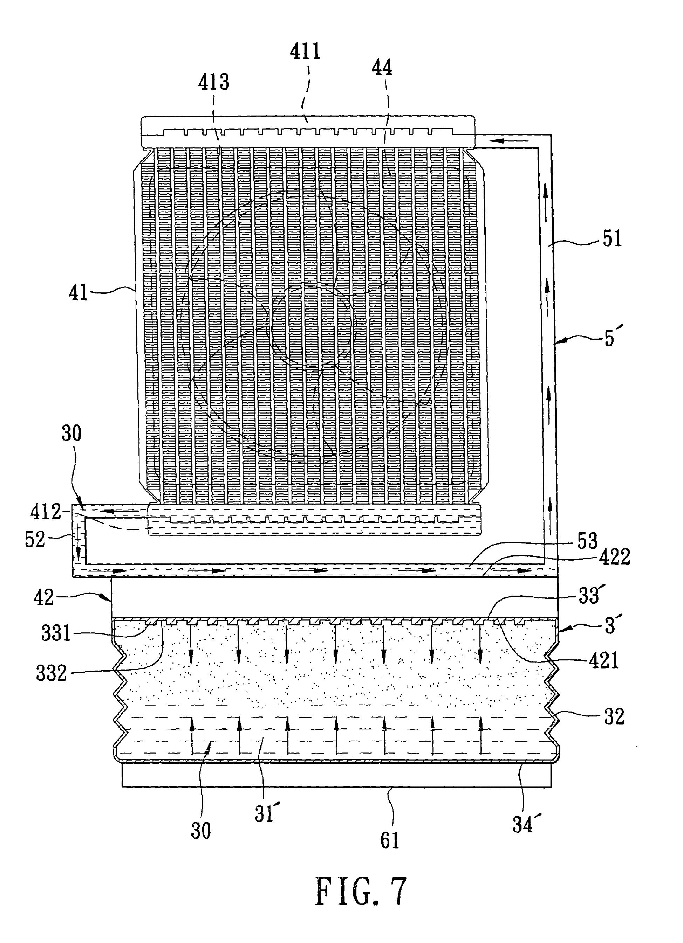

Referring to Figure 7, a heat dissipating system according to the third preferred embodiment of the present invention is shown to be similar to the first preferred embodiment. However, in this embodiment, the receiving space 31' of the heat dissipating cavity body 3' is tightly closed, and is non-communicated with the condenser 41 and the tubing unit 5' . The top wall 33' has an inner surface formed with a plurality of protrusions 331 and depressions 332 so as to increase a surface area of the inner surface of the top wall 33'. The cold side 421 of the thermoelectric cooler 42 is directly in contact with the top wall 33' of the cavity body 3'. The tubing unit 5' further includes an intermediate tube 53 connected fluidly between the vapor-flowing and liquid-flowing tubes 51, 52 and in contact with the hot side 422 of the thermoelectric cooler 42. The working fluid 30 is further disposed in the condenser 41 and the tubing unit 5'.

When the liquid-state working fluid 30 in the receiving space 31' absorbs heat generated by the heat source 61, it will vaporize upwardly toward the top wall 33' . The vaporized working fluid 30 then exchanges heat with the cavity body 3'. Through the cooling function of the cold side 421 of the thermoelectric cooler 42, the vaporized working fluid 30 condenses, and flows downwardly to the bottom wall 34' so as to repeat the aforementioned vaporization and condensation processes.

The hot side 422 of the thermoelectric cooler 42, on the other hand, transfers heat resulting from condensation of the vaporized working fluid 30 in the cavity body 3' to the intermediate tube 53 so as to vaporize the liquid-state working fluid 30 in the intermediate tube 53. The vaporized working fluid 30 in the intermediate tube 53 then flows upward by natural convection to the vapor-receiving section 411 of the condenser 41 through the vapor-flowing tube 51, exchanges heat with the condenser 41, condenses, flows downward through the channels 413 by gravity into the liquid-receiving section 412 of the condenser 41, and back into the intermediate tube 53 through the liquid-flowing tube 52 so as to repeat the aforementioned steps. Hence, heat dissipation is similarly and efficiently achieved using the third preferred embodiment.

It should be noted that the fan 44 may be attached to one side of the condenser 41 depending on the size of the condenser 41. As such, the heat dissipating effect and efficiency of the condenser 41 may be enhanced. Further, in the first or second preferred embodiment, the tubing unit 5 may interconnect in series or in parallel a plurality of the heat dissipating cavity bodies 3, which in turn, are adapted to contact respectively heat sources of the computer module 6.

The heat dissipating system of the present invention may also be applicable to an engine or a machine of a car, or any other article that needs heat dissipation.

From the aforementioned description, the advantages of the heat dissipating system of the present invention may be summarized as follows:
1. Since the heat dissipating cavity body 3, 7, 3' is deformable, the bottom wall 34, 74, 34' thereof can contact tightly the contact surface of the heat source 61 so that the heat dissipating effect and efficiency during heat conduction are enhanced.
2. The working fluid 30 of the present invention, while in a liquid state, can effectively absorb heat from the heat source 61 through heat conduction, and is then vaporized so as to exchange heat with the heat exchange unit 4. Further, through flowing of the working fluid 30 in a liquid state from a high place to a low place by gravity, and through flowing of the working fluid 30 in a vapor state from a high-density region to a low-density region by natural convection, the working fluid 30 can undergo a self-circulating effect, so that the system of the present invention not only reduces noise to a minimum (by not requiring a separate pump), but also can enhance the heat dissipating effect and efficiency thereof.
3. The working fluid 30 of the present invention makes use of a coolant or a super-thermal-conductive liquid, so that no freezing of the working fluid 30 is likely to occur when the system is used in cold temperature environments of below 0°C . Hence, the heat dissipation process can be carried out smoothly. Further, even if there is a leak in the system, the working fluid 30 will turn immediately into vapor so as not to damage electronic circuitry and/or elements of the heat dissipating system.

## Claims

1. A heat dissipating system, **characterized by**:
a heat dissipating cavity body (3, 7, 3') defining a receiving space (31, 31') and having a bottom wall (34, 74, 34') adapted to contact a heat source (61) ;
a working fluid (30) disposed in said receiving space (31, 71, 31') and adapted to absorb heat generated by the heat source (61); and
a heat exchange unit (4) for exchanging heat with said working fluid (30);
wherein said bottom wall (34, 74, 34') is made of a thin metal plate and is flexible to deform so that when said bottom wall (34, 74, 34') is pressed against the heat source (61), said bottom wall (34, 74, 34') conforms to and contacts tightly a contact surface of the heat source (61).

2. The heat dissipating system of Claim 1, **characterized in that** said bottom wall (34, 74, 34') has a thickness of below 0.5mm.

3. The heat dissipating system of Claim 1, **characterized in that** said bottom wall (34) is convexed downwardly and toward the heat source (61).

4. The heat dissipating system of Claim 1, **characterized in that** said bottom wall (74) is flat.

5. The heat dissipating system of Claim 1, **characterized in that** said heat dissipating cavity body (3, 3') further has a pleated surrounding wall (32) connected to said bottom wall (34, 34').

6. The heat dissipating system of Claim 1, **characterized in that** said heat dissipating cavity body (3') further has a top wall (33'), said heat exchange unit (4) including a thermoelectric cooler (42) that has a cold side (421) in contact with said top wall (33'), and a hot side (422) opposite to said cold side (421), said working fluid (30) being a condensable fluid movable upward toward said top wall (33') when vaporized and movable downward toward said bottom wall (34') when condensed.

7. The heat dissipating system of Claim 6, **characterized in that** said top wall (33') has a non-planar inner surface.

8. The heat dissipating system of Claim 7 , **characterized in that** said inner surface of said top wall (33') is formed with a plurality of protrusions and depressions (331, 332).

9. The heat dissipating system of Claim 6, **characterized in that** said heat exchange unit (4) further includes a condenser (41), and a tubing unit (5') in contact with said hot side (422) of said thermoelectric cooler (42) and connected fluidly to said condenser (41), said condenser (41) and said tubing unit (5') being non-communicated with said heat dissipating cavity body (3'), said working fluid (30) being further disposed in said condenser (41) and said tubing unit (5').

10. A heat dissipating cavity body (3, 7, 3') adapted to contact a heat source (61), said heat dissipating cavity body (3, 7, 3') **characterized by**:
top and bottom walls (33, 73, 33', 34, 74, 34') ; and
a surrounding wall (32, 72) connected between said top and bottom walls (33, 73, 33', 34, 74, 34') to define a receiving space (31, 71, 31') which is adapted to contain a working fluid (30);
wherein said bottom wall (34, 74, 34') is made of a thin metal plate and is flexible to deform so that when said bottom wall (34, 74, 34') is pressed against the heat source (61), said bottom wall (34, 74, 34') conforms to and contacts tightly a contact surface of the heat source (61).

11. The heat dissipating cavity body of Claim 10, **characterized in that** said bottom wall (34, 74, 34') has a thickness of below 0.5mm.

12. The heat dissipating cavity body of Claim 10, **characterized in that** said bottom wall (34) is convexed downwardly and toward the heat source (61) .

13. The heat dissipating cavity body of Claim 10, **characterized in that** said bottom wall (74) is flat.

14. The heat dissipating cavity body of Claim 10, **characterized in that** said surrounding wall (32) is pleated.

15. The heat dissipating cavity body of Claim 10, **characterized in that** said top wall (33') has a non-planar inner surface.

16. The heat dissipating cavity body of Claim 15, **characterized in that** said inner surface of said top wall (33') is formed with a plurality of protrusions and depressions (331, 332).
